# EUROPEAN PATENT APPLICATION

(11) **EP 0 635 889 A1**
(43) Date of publication of application: **25.01.1995**
(21) Application number: 94115450.2
(22) Date of filing: 30.04.1990
(51) Int. Cl.: H01L 29/747, H03K 17/08

(54) **Bidirectional control rectifying semiconductor apparatus**

(30) Priority: 01.05.1989 JP 109050/89
(62) Divisional of application: 90108273.5
(71) Applicant: KABUSHIKI KAISHA TOSHIBA, Kawasaki-shi, Kanagawa-ken 210 (JP)
(72) Inventor: Miwa, Junichi, c/o Int. Prop. Div., Minato-ku, Tokyo 105 (JP); Asakura, Kouichi, c/o Int. Prop. Div., Minato-ku, Tokyo 105 (JP)
(74) Representative: Lehn, Werner, Dipl.-Ing.

(57) **Abstract**

This invention discloses a bidirectional control rectifying semiconductor apparatus having a sub thyristor which is composed of third and fourth conductive layers (3, 4) of a second conductivity type and is composed of sixth and seventh conductive layers (6, 7) of a first conductive type, and in which a first capacitor (15) is arranged between the third end sixth conductive layers (3, 6) and a second capacitor (16) is arranged between the fourth and seventh conductive layers (4, 7).

## Description

The present invention relates to a bidirectional control rectifying semiconductor apparatus and, more particularly, to a bidirectional control rectifying semiconductor apparatus having a high gate sensitivity capable of driving an element by a small current.

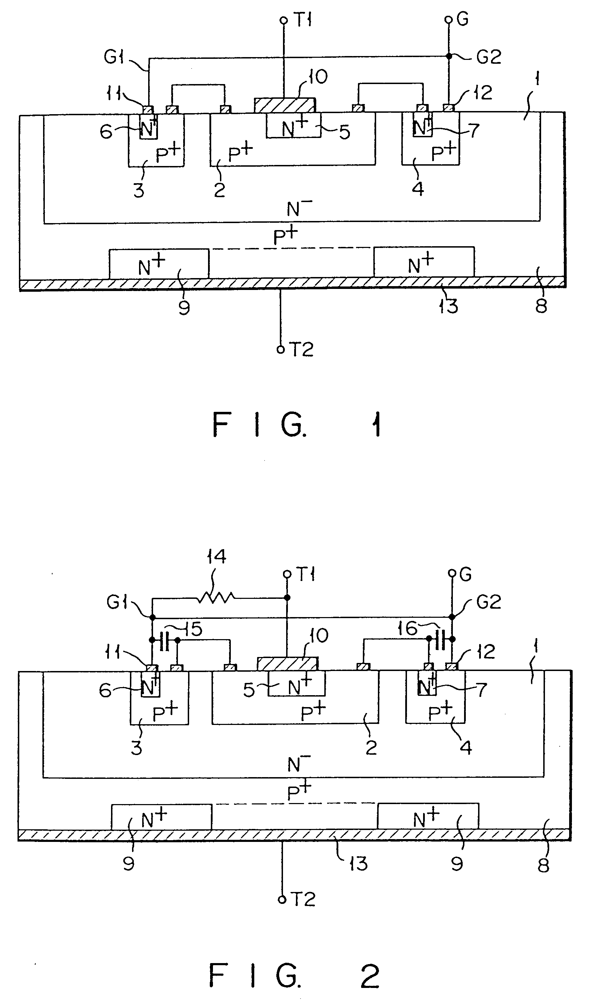

Fig. 1 shows a sectional view showing a TRIAC which is one type of bidirectional control rectifying semiconductor apparatus. That is, an eighth conductive layer 8 as a p⁺-type conductive layer is formed on the lower and side surfaces of a first conductive layer 1 serving as an n⁻-type substrate by a known technique. A ninth conductive layer 9 as an n⁺-type conductive layer is formed in the lower surface region of the eighth conductive layer 8. A second electrode 13 is arranged on the lower surface of the eighth conductive layer 8 and a terminal of the second electrode 13 is represented by T₂. As shown in Fig. 1, three p⁺-type conductive layers, i.e., second, third, and forth conductive layers 2, 3, and 4, are formed in the surface region of the first conductive layer 1. N⁺-type conductive layers, i.e., fifth, sixth, and seventh conductive layers 5, 6, and 7, are formed in the surface regions of the conductive layers 2, 3, and 4, respectively. A first electrode 10 is arranged on the surfaces of the fifth conductive layer 5 and the second conductive layer 2, and a terminal of the first electrode 10 is represented by T₁. The second and third conductive layers 2 and 3 and the second and seventh conductive layers 2 and 7 are connected through Aℓ wiring layers, respectively. First and second gate electrodes 11 and 12 are arranged on the sixth and fourth conductive layers 6 and 4, respectively. Terminals of the first and second gate electrodes 11 and 12 are represented by G₁ and G₂, respectively. The terminals G₁ and G₂ of the first and second gate electrodes 11 and 12 are connected to each other through an Aℓ wiring layer to obtain a common terminal G.

First, an operation principle of the conventional TRIAC will be described. There are four modes I, II, III, and IV for turning on the TRIAC having such an arrangement. In the mode I (T₂+, G+), the TRIAC performs the same operation as in a conventional amplifying gate thyristor. In the mode II (T₂+, G-), the terminal G₁ section of the first gate electrode 11 performs a negative bias junction thyristor operation. In the mode III (T₂-, G-), the terminal G₁ section of the first gate electrode 11 performs a remote gate operation. In the mode IV (T₂-, G+), the terminal G₂ section of the second gate electrode 12 performs the remote gate operation (the terminal T₁ section of the first electrode 10 secondarily performs the remote gate operation). Since a sub thyristor section of the conventional TRIAC, formed by the third and forth conductive layers 3 and 4 and the sixth and seventh conductive layers 6 and 7, has a non-shorted structure, a resistor is arranged outside the TRIAC between the terminal T₁ of the first electrode 10 and the common terminal G of the first and second gate electrodes 11 and 12 to adjust a resistance R_{GK}, and an emitter junction in the sub thyristor section is made shallow to reduce a gate sensitivity and improve a dv/dt withstand amount. The dv/dt withstand amount is a dv/dt value corresponding to an ignition error of a thyristor when an abruptly leading voltage is applied to a gate of the thyristor and a displacement current flows into a base section of the thyristor.

In the conventional TRIAC, a main thyristor section is undesirably turned on by an erroneous operation of the sub thyristor section caused by the abruptly leading voltage. In a practical application, the dv/dt withstand amount is improved by arranging external resistors or capacitors.

The present invention has been made in consideration of the above situation, and has as its object to provide a TRIAC, wherein a dv/dt withstand amount is improved by incorporating a capacitor in a sub thyristor section of the TRIAC.

A bidirectional control rectifying semiconductor apparatus according to the present invention comprises:
a first conductive layer of a first conductivity type;
second, third, and fourth conductive layers of a second conductivity type formed in one major surface region of the first conductive layer and separated from each other;
a fifth conductive layer of the first conductivity type formed in a surface region of the second conductive layer;
a sixth conductive layer of the first conductivity type formed in a surface region of the third conductive layer;
a seventh conductive layer of the first conductivity type formed in a surface region of the fourth conductive layer;
an eighth conductive layer of the second conductivity type formed on the other major surface region and side portions of the first conductive layer;
a ninth conductive layer of the first conductivity type formed in a surface region of the eighth conductive layer;
a first electrode overlapping the second and fifth conductive layers;
a second electrode arranged on the eighth conductive layer;
wherein the second conductive layer and the third conductive layer are connected through a first wiring layer;
the second conductive layer and the seventh conductive layer are connected through a second wiring layer;
a first capacitor is arranged between the third conductive layer and the sixth conductive layer; and
a second capacitor is arranged between the fourth conductive layer and the seventh conductive layer.

According to the present invention, by incorporating a capacitor in the sub thyristor section of the TRIAC, the same effect as an increase in junction capacity of a G-K path of the sub thyristor section (e.g., between the sixth and seventh conductive layers) can be obtained, and a dv/dt withstand amount is increased. For example, when a resistor having a resistance R_{GK} of about 1 kΩ, and a capacitor having a capacitance of 100 to 1,000 pF are incorporated in the sub thyristor section, the dv/dt withstand amount is improved by 50 V/µs or more in comparison with a TRIAC without an incorporated capacitor.

This invention can be more fully understood from the following detailed description when taken in conjunction with the accompanying drawings, in which:
Fig. 1 is a sectional view showing a TRIAC which is one type of bidirectional control rectifying semiconductor apparatus;
Fig. 2 is a schematic view showing a TRIAC employing a bidirectional control rectifying semiconductor apparatus according to the present invention;
Fig. 3 is a TRIAC in which a second capacitor shown in Fig. 2 is practically incorporated as a wafer device;
Fig. 4 is a planar pattern capable of incorporating the second capacitor shown in Fig. 3;
Fig. 5 is a sectional view showing the pattern along the line A-A in Fig. 4;
Fig. 6 is a schematic view showing a TRIAC according to the another embodiment of the present invention; and
Fig. 7 is a detailed arrangement of a TRIAC as a wafer device incorporating a second capacitor shown in Fig. 6.

An embodiment of the present invention will be described in detail with reference to the accompanying drawings. As shown in Fig. 2, an eighth conductive layer 8 as a p⁺-type conductive layer is formed on the lower and side surfaces of a first conductive layer 1 serving as an n⁻-type substrate by a known technique. A ninth conductive layer 9 as an n⁺-type conductive layer is formed in the lower surface region of the eighth conductive layer 8. A second electrode 13 is arranged on the lower surface of the eighth conductive layer 8 and a terminal of the second electrode 13 is represented by T₂. As shown in Fig. 2, three p⁺-type conductive layers, i.e., second, third, and forth conductive layers 2, 3, and 4, are formed in the surface region of the first conductive layer 1. N⁺-type conductive layers, i.e., fifth, sixth, and seventh conductive layers 5, 6, and 7, are formed in the surface regions of the conductive layers 2, 3, and 4, respectively. A first electrode 10 is arranged on the surfaces of the second conductive layer 2 and the fifth conductive layer 5, and a terminal of the first electrode 10 is represented by T₁. The second and third conductive layers 2 and 3 and the second and seventh conductive layers 2 and 7 are connected through Aℓ wiring layers, respectively.

First and second gate electrodes 11 and 12 are arranged on the sixth and fourth conductive layers 6 and 4, respectively. Terminals of the first and second gate electrodes 11 and 12 are represented by G₁ and G₂, respectively. The terminals G₁ and G₂ are connected to each other through an Aℓ wiring layer to define a common terminal of the terminals G₁ and G₂ as an electrode G. The first and second gate electrodes 11 and 12 are connected to the first electrode through a resistor 14 consisting of polysilicon or the like formed on the surface of the first conductive layer 1. A first capacitor 15 is arranged between the third conductive layer 3 and the first gate electrode 11. A second capacitor 16 is arranged between the seventh conductive layer 7 and the second gate electrode 12.

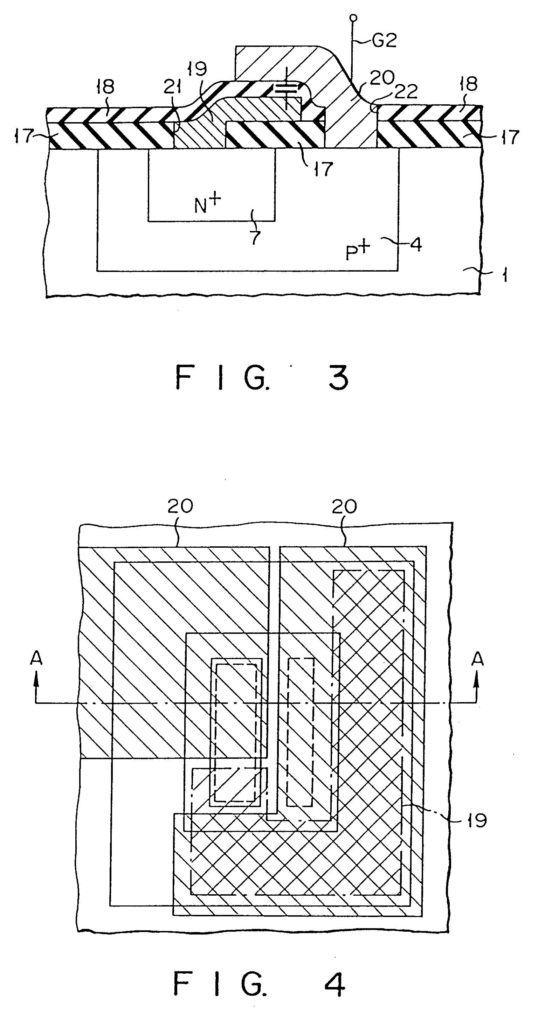

Fig. 2 is a schematic view showing a TRIAC employing a bidirectional control rectifying semiconductor apparatus according to the present invention. Fig. 3 shows a TRIAC in which the second capacitor 16 shown in Fig. 2 is practically incorporated as a wafer device.

In Fig. 3, a first oxide film 17 is formed on the surface of a first conductive layer 1. First and second contact holes 21 and 22 are formed in the first oxide film 17. A second oxide film 18 is formed on the first oxide film 17. Reference numeral 19 denotes a polysilicon layer which is formed between the first and second oxide films 17 and 18 and one end of which is in contact with a seventh conductive layer 7 through the first contact hole 21.

Reference numeral 20 denotes an aluminum layer which is formed on the second oxide layer 8, one end of which is in contact with a fourth conductive layer 4 through the second contact hole 22 formed in the first and second oxide films 17 and 18, and the other end of which extends on the polysilicon layer 19. The aluminum layer 20 serves as a second gate electrode G₂.

A second capacitor 16 is formed by the second oxide film 18 and the polysilicon layer 19.

Fig. 4 shows a planar pattern capable of incorporating a second capacitor 16 in a TRIAC without increasing a chip area when the second capacitor 16 is arranged between a seventh conductive layer 7 and a second gate electrode 12.

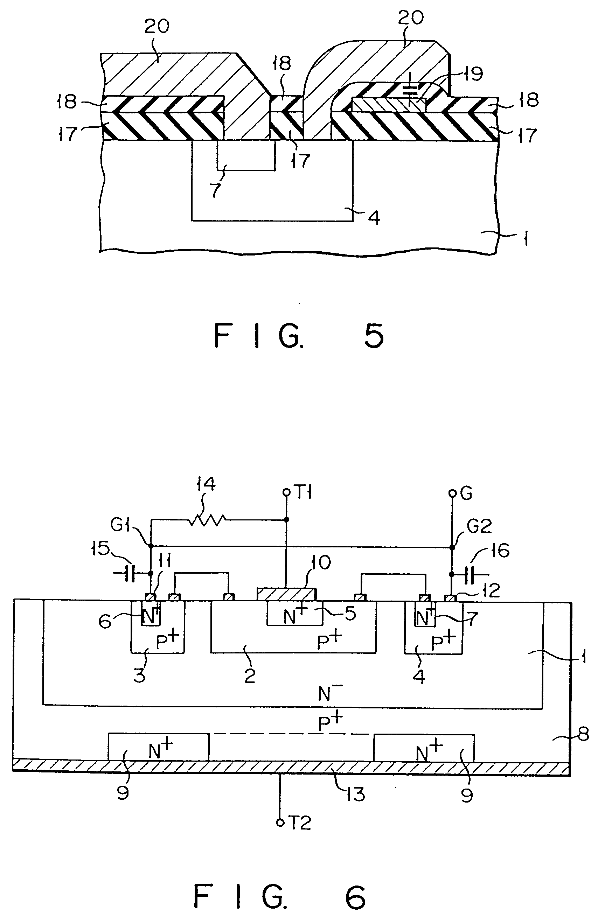

Fig. 5 is a sectional view showing the pattern along the line A - A in Fig. 4.

By employing the arrangement shown in Figs. 4 and 5, a capacitor can be formed under a gate electrode. Therefore, the capacitor can be incorporated in a TRIAC without increasing a chip area.

The same reference numerals as in Fig. 3 denote the same or corresponding parts in Figs. 4 and 5.

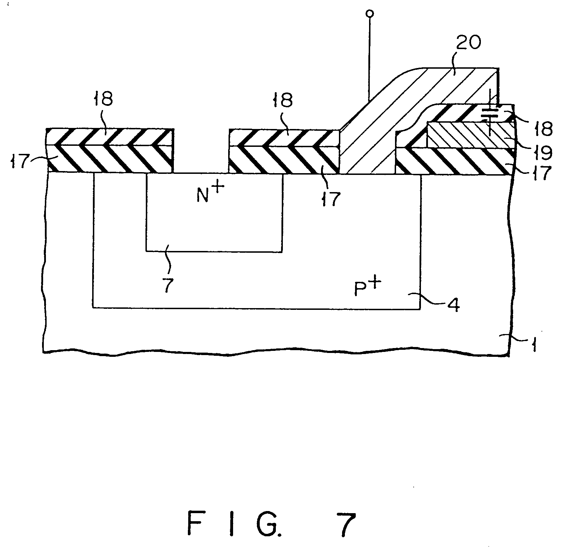

Fig. 6 is a schematic view showing a TRIAC in which first and second capacitors 15 and 16 are disconnected from third and seventh conductive layers 3 and 7, respectively.

Fig. 7 shows a detailed arrangement of a TRIAC as a wafer device incorporating the second capacitor 16 shown in Fig. 6 in a practical application.

The same reference numerals as in Fig. 2 denote the same or corresponding parts in Fig. 6. The same reference numerals as in Figs. 3 and 5 denote the same or corresponding parts in Fig. 7.

Reference signs in the claims are intended for better understanding and shall not limit the scope.

## Claims

1. A bidirectional control rectifying semiconductor apparatus comprising:
a first conductive layer (1) of a first conductivity type;
second, third, and fourth conductive layers (2,3,4) of a second conductivity type formed in one major surface region of said first conductive layer (1) and separated from each other;
a fifth conductive layer (5) of the first conductivity type formed in a surface region of said second conductive layer (2);
a sixth conductive layer (6) of the first conductivity type formed in a surface region of said third conductive layer (3);
a seventh conductive layer (7) of the first conductivity type formed in a surface region of said fourth conductive layer (4);
an eighth conductive layer (8) of the second conductivity type formed on the other major surface region and side portions of said first conductive layer (1);
a ninth conductive layer (9) of the first conductivity type formed in a surface region of said eight conductive layer (8);
a first electrode (10) overlapping said second and fifth conductive layers (2,5); and
a second electrode (13) arranged on said eighth conductive layer (8);
wherein said second conductive layer (2) and said third conductive layer (3) are connected through a first wiring layer;
said second conductive layer (2) and said seventh conductive layer (7) are connected through a second wiring layer;
a first capacitor (15), one end of which is connected to said sixth conductive layer (6), is arranged on said first conductive layer (1); and
a second capacitor (16), one end of which is connected to said fourth conductive layer (4), is arranged on said first conductive layer (1).

2. An apparatus according to claim 1, characterised in that a resistor (14) is arranged between said first electrode (T₁) and said gate electrode (G).

3. A bidirectional control rectifying semiconductor apparatus comprising:
a first conductive layer (1) of a first conductivity type;
second, third, and fourth conductive layers (2,3,4) of a second conductivity type formed in one major surface region of said first conductive layer (1) and separated from each other;
a fifth conductive layer (5) of the first conductivity type formed in a surface region of said second conductive layer (2);
a sixth conductive layer (6) of the first conductivity type formed in a surface region of said third conductive layer (3);
a seventh conductive layer (7) of the first conductivity type formed in a surface region of said fourth conductive layer (4);
an eighth conductive layer (8) of the second conductivity type formed on the other major surface region and side portions of said first conductive layer (1);
a ninth conductive layer (9) of the first conductivity type formed in a surface region of said eighth conductive layer (8);
a first electrode (10) overlapping said second and fifth conductive layers (2,5); and
a second electrode (13) arranged on said eighth conductive layer (8);
wherein said second conductive layer (2) and said third conductive layer (3) are connected through a first wiring layer;
said second conductive layer (2) and said seventh conductive layer (7) are connected through a second wiring layer;
said fourth conductive layer (4) and said sixth conductive layer (6) are connected through a third wiring layer to define a terminal of said third wiring layer as a gate electrode (G);
a first capacitor (15) is arranged between said third conductive layer (3) and said sixth conductive layer (6); and
a second capacitor (16) is arranged between said fourth conductive layer (4) and said seventh conductive layer (7).

4. Apparatus according to claim 3, characterised in that a resistor (14) is arranged between said first electrode (T₁) and said gate electrode (G)
